(19) Europäisches Patentamt / European Patent Office / Office européen des brevets

(11) **EP 4 419 933 B1**

(12) **EUROPÄISCHE PATENTSCHRIFT**

(45) Veröffentlichungstag und Bekanntmachung des Hinweises auf die Patenterteilung:
**06.08.2025 Patentblatt 2025/32**

(21) Anmeldenummer: **22808956.1**

(22) Anmeldetag: **19.10.2022**

(51) Internationale Patentklassifikation (IPC):
*G01R 33/383* (2006.01)  *G01R 33/60* (2006.01)
*G01N 24/10* (2006.01)  *G07D 7/04* (2016.01)
*G01N 24/08* (2006.01)  *H01F 7/02* (2006.01)
*G01R 33/30* (2006.01)

(52) Gemeinsame Patentklassifikation (CPC):
**G01R 33/383; G01N 24/08; G01N 24/10; G01R 33/60; G07D 7/04; H01F 7/0294;**
G01R 33/307

(86) Internationale Anmeldenummer:
**PCT/EP2022/025477**

(87) Internationale Veröffentlichungsnummer:
**WO 2023/066523 (27.04.2023 Gazette 2023/17)**

(54) **SENSORELEMENT FÜR DIE PRÜFUNG EINES DATENTRÄGERS MIT SPINRESONANZ-MERKMAL, ZERLEGEVERFAHREN, MONTAGEVERFAHREN UND PRÜFVERFAHREN**

SENSOR ELEMENT FOR TESTING A DATA CARRIER HAVING A SPIN RESONANCE FEATURE, DIVIDING METHOD, MOUNTING METHOD AND TESTING METHOD

ÉLÉMENT CAPTEUR CONÇU POUR LE CONTRÔLE D'UN SUPPORT DE DONNÉES PRÉSENTANT UNE CARACTÉRISTIQUE DE RÉSONANCE DE SPIN, PROCÉDÉ DE SÉPARATION, PROCÉDÉ DE MONTAGE ET PROCÉDÉ DE CONTRÔLE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **21.10.2021 DE 102021005253**

(43) Veröffentlichungstag der Anmeldung:
**28.08.2024 Patentblatt 2024/35**

(73) Patentinhaber: **Giesecke+Devrient Currency Technology GmbH**
**81677 München (DE)**

(72) Erfinder:
• **HUBER, Stephan**
  80634 München (DE)
• **SCHULLER, Christian**
  84513 Erharting (DE)
• **HAPP, Thomas**
  81825 München (DE)

(74) Vertreter: **Giesecke+Devrient IP Prinzregentenstraße 161 81677 München (DE)**

(56) Entgegenhaltungen:
CN-U- 203 931 702      DE-A1- 3 408 086
JP-A- 2006 128 234     SU-A1- 1 054 752
US-A- 5 149 946

## Beschreibung

Die Erfindung betrifft ein Sensorelement für die Prüfung eines flächigen Datenträgers, insbesondere einer Banknote, mit einem Spinresonanz-Merkmal. Die Erfindung betrifft auch ein Verfahren zum Zerlegen eines solchen Sensorelements, ein Verfahren zur Montage eines solchen Sensorelements und ein Verfahren zur Prüfung eines flächigen Datenträgers mit einem Spinresonanz-Merkmal mittels eines solchen Sensorelements.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Es ist bekannt, bei der maschinellen Echtheitsprüfung Sicherheitselemente mit Spinresonanz-Merkmalen zur Absicherung von Dokumenten und anderen Datenträgern einzusetzen. Die Sicherheitselemente sind dazu mit Substanzen versehen, die eine Spinresonanz-Signatur aufweisen. Zu den für die Echtheitsprüfung einsetzbaren Spinresonanz-Signaturen gehören insbesondere Kernspin-Resonanz-Effekte (Nuclear Magnetic Resonance, NMR) Elektronspin-Resonanz-Effekte (ESR) und ferro- bzw. ferrimagnetische Resonanz-Effekte (FMR).

Bei der Prüfung von Banknoten werden zur Detektion der Spinresonanz-Signaturen meist drei verschiedene Magnetfelder im Messbereich beispielsweise einer Banknotenbearbeitungsmaschine erzeugt. Dabei handelt es sich konkret um ein quasistatisches Polarisationsfeld $B_0$, das parallel zur Axialrichtung (z-Richtung) des Luftspalts eines magnetischen Kreises verläuft. Ein zweites Magnetfeld ist durch ein Modulationsfeld $B_{mod}$ gebildet, welches ebenfalls parallel zur z-Achse verläuft und typischerweise eine Frequenz $f_{mod}$ im kHz-Bereich hat. Zur Anregung von Übergängen zwischen den aufgespaltenen Spin-Energieniveaus der Spinresonanz-Signatur-Substanzen ist ein Anregefeld $B_1$ vorgesehen, das senkrecht zur $B_0$-Richtung polarisiert ist. Das Anregefeld schwingt dabei mit der Resonanzfrequenz des Materials, die auch als Larmorfrequenz bezeichnet wird, und die proportional zum Polarisationsfeld $B_0$ ist. Bei NMR-Anwendungen ist die Larmorfrequenz typischerweise kleiner als 100 MHz, während bei ESR- und FMR-Anwendungen die Larmorfrequenz typischerweise größer als 1 GHz ist.

Zur Erzeugung des Polarisationsfeldes $B_0$ kommt häufig ein magnetischer Kreis zum Einsatz, der den magnetischen Fluss von Permanentmagneten und/oder Spulen zu dem Luftspalt leitet, in dem die Banknotenprüfung stattfindet. Die gemessene Spinresonanz-Signalstärke steigt dabei in etwa quadratisch mit der Feldstärke $B_0$ an, so dass das Polarisationsfeld für die Messung vorteilhaft maximiert wird. Ein größeres Polarisationsfeld $B_0$ führt allerdings auch zu größeren Kräften und Streufeldern zwischen den Einzelkomponenten des magnetischen Kreises, die insbesondere bei permanent-magnetischen Kreisen problematisch sein können. Muss der magnetische Kreis beispielsweise für Montage-, Wartungs- oder Installationsaufgaben zusammengebaut oder zerlegt werden, so werden die Arbeiten durch die wirkenden großen Kräfte erschwert und/oder können eine Gefährdung darstellen.

Eine weitere Gefährdung kann auftreten, wenn der magnetische Kreis in seine Einzelteile zerlegt und eingelagert wird. In diesem Fall entstehen magnetische Streufelder im Umfeld der Kreis-Komponenten, deren Stärke mit größer werdendem Polarisationsfeld $B_0$ ansteigt. Magnetisierbare Teile werden von diesen Streufeldern angezogen, was die Lagerung erschwert.

CN 203 931 702 U betrifft ein H-förmiges Permanentmagnetgerät für Lehrexperimentiergeräte zur Kernspinresonanz. Das Gerät besteht aus einem Magnetrahmen, einem Helmholtz-Spulenpaar, einem Polschuh aus Reineisen, magnetischem Neodym-Eisen-Bor-Stahl, einem verstellbaren Magnetjoch, einer Innensechskantschraube, einer verstellbaren Feststellschraube und einer verstellbaren Auswerferschraube nach außen. Sechs Justierungsschrauben am Magnetjoch dienen zur Feineinstellung der Gleichmäßigkeit eines Magnetfelds, und die Feldvereinheitlichungs- und Regulierungsfunktionen können zusätzlich durch zwei Sätze Helmholtz-Spulen erreicht werden; der Neodym-Eisen-Bor-Magnetstahl ist durch eine Abschirmung gepaart, das Magnetjoch aus reinem Eisen ist fein geschliffen und eine hohe Gleichmäßigkeit einer Magnetvorrichtungsanordnung ist gewährleistet. Das Gerät ist einfach zu installieren, weist eine hohe Gleichmäßigkeit auf und kann in der Lehre für Experimentiergeräte zur kontinuierlichen Kernspinresonanz und zur gepulsten Kernspinresonanz eingesetzt werden.

Ausgehend davon liegt der Erfindung die Aufgabe zugrunde, ein verbessertes Sensorelement für die Prüfung eines flächigen Datenträgers mit einem Spinresonanz-Merkmal anzugeben, das einfach und sicher zusammengebaut und zerlegt werden kann, und in zerlegtem Zustand sicher eingelagert werden kann.

Diese Aufgabe wird durch die Merkmale der unabhängigen Ansprüche gelöst. Weiterbildungen der Erfindung sind Gegenstand der abhängigen Ansprüche.

Die Erfindung stellt ein Sensorelement für die Prüfung eines flächigen Datenträgers mit einem Spinresonanz-Merkmal bereit. Bei dem flächigen Datenträger kann es sich beispielsweise um eine Banknote handeln, die einer Echtheitsprüfung unterzogen wird. Das Sensorelement enthält einen Magnetkern mit einem Luftspalt, in den der flächige Datenträger zur Prüfung einbringbar ist. Der Magnetkern enthält auch zumindest einen Zerlegespalt, entlang dem der Magnetkern in zwei oder mehr Teile zerlegbar ist. Das Sensorelement enthält weiter eine Polarisationseinrichtung zur Erzeugung eines statischen magnetischen Flusses in dem Luftspalt.

Als Besonderheit ist bei dem Sensorelement vorgesehen, dass der Magnetkern zumindest ein zwischen zwei Zuständen schaltbares magnetisches Potentiometer aufweist,
wobei

- das magnetische Potentiometer in einem ersten Zustand einen ersten magnetischen Widerstand aufweist und das Sensorelement in dem ersten Zustand des magnetischen Potentiometers auf eine Messung an einem Spinresonanz-Merkmal eines in den Luftspalt eingebrachten Datenträgers eingerichtet ist, und
- das magnetische Potentiometer in einem zweiten Zustand einen vom ersten magnetischen Widerstand unterschiedlichen zweiten magnetischen Widerstand aufweist und das Sensorelement in dem zweiten Zustand des magnetischen Potentiometers auf eine Zerlegung des Magnetkerns entlang des Zerlegespalts eingerichtet ist.

Das zumindest eine magnetische Potentiometer ist mit Vorteil so ausgebildet, dass es im ersten Zustand im Wesentlichen keinen Einfluss auf den magnetischen Fluss im Luftspalt hat.

Mit Vorteil ist die Zerlegekraft zur Zerlegung des Magnetkerns entlang des zumindest einen Zerlegespalts im zweiten Zustand zumindest 20%, insbesondere um zumindest 40%, kleiner als die Zerlegekraft im ersten Zustand.

Dabei ist in einer bevorzugten Ausgestaltung vorgesehen, dass für eine Zerlegung des Magnetkerns ein magnetischer Leiter mit einem magnetischen Widerstand $R_{ref}$ mit Hilfe eines magnetischen Potentiometers zu überbrücken ist, wobei das magnetische Potentiometer parallel zu dem zu überbrückenden Leiter geschaltet ist.

Das magnetische Potentiometer weist dabei vorteilhaft im ersten Zustand einen magnetischen Widerstand $R_P$ von mindestens $10*R_{ref}$ auf. Vorzugsweise ist der magnetische Widerstand $R_P$ im ersten Zustand sogar größer als $20*R_{ref}$ oder $50*R_{ref}$. Alternativ oder zusätzlich weist das magnetische Potentiometer im zweiten Zustand einen magnetischen Widerstand $R_P$ von höchstens $3*R_{ref}$ auf. Vorzugsweise ist der magnetische Widerstand $R_P$ im zweiten Zustand sogar kleiner als $2*R_{ref}$ oder $1*R_{ref}$.

In einer anderen, ebenfalls bevorzugten Ausgestaltung ist vorgesehen, dass für eine Zerlegung des Magnetkerns ein magnetischer Leiter mit einem magnetischen Widerstand $R_{ref}$ mit Hilfe eines magnetischen Potentiometers flussfrei zu schalten ist, wobei das magnetische Potentiometer in Serie mit dem flussfrei zu schaltenden Leiter geschaltet ist.

Das magnetische Potentiometer weist dabei vorteilhaft im ersten Zustand einen magnetischen Widerstand $R_P$ von höchstens $1/3*R_{ref}$ auf. Vorzugsweise ist der magnetische Widerstand $R_P$ im ersten Zustand sogar kleiner als $1/5*R_{ref}$ oder $1/10*R_{ref}$. Alternativ oder zusätzlich weist das magnetische Potentiometer im zweiten Zustand einen magnetischen Widerstand $R_P$ von mindestens $3*R_{ref}$ auf. Vorzugsweise ist der magnetische Widerstand $R_P$ im zweiten Zustand sogar größer als $5*R_{ref}$ oder $10*R_{ref}$.

Gemäß einer vorteilhaften Ausgestaltung ist vorgesehen, dass im zweiten Zustand des magnetischen Potentiometers der magnetische Fluss durch den Luftspalt gegenüber dem magnetischen Fluss im ersten Zustand um mehr als 5% verändert ist, und/oder dass die Feldhomogenität im Luftspalt um mehr als 10% verringert ist. Dies erlaubt eine besonders große Reduktion der Zerlegekraft.

Bei dem Sensorelement sind vorteilhaft zwei oder mehr magnetische Potentiometer, insbesondere magnetische Potentiometer unterschiedlichen Typs vorgesehen. Dies ermöglicht eine starke Reduktion der Zerlegekraft bei gleichzeitig kleiner Baugröße und leichter Beweglichkeit der Potentiometer. Dabei kommen vorzugsweise die magnetischen Potentiometer der nachfolgend genauer beschriebenen Typen in Betracht.

Gemäß einer vorteilhaften Ausgestaltung umfasst zumindest ein magnetisches Potentiometer des Magnetkerns zwei beabstandete magnetische Leiter und ein magnetisches Flussleitstück, welches sich mit variabler Länge im Freiraum zwischen den beiden Leitern erstreckt, um abhängig von der Länge des Flussleitstücks einen variablen magnetischen Widerstand zu erzeugen. Das magnetische Flussleitstück kann beispielsweise ein magnetischer Zylinder sein und insbesondere durch einen verschiebbaren Bolzen oder eine Gewindestange gebildet sein. Die Länge des Flussleitstücks im Freiraum kann zwischen Null und dem Abstand der magnetischen Leiter variieren. Die beiden oben genannten Zustände des magnetischen Potentiometers mit unterschiedlichem Widerstand können durch eine Stellung minimaler bzw. maximaler Länge des Flussleitstücks im Freiraum gebildet sein. Diese Ausführungsform erlaubt eine besonders starke Verringerung der Zerlegekraft.

Gemäß einer anderen vorteilhaften Ausgestaltung umfasst zumindest ein magnetisches Potentiometer des Magnetkerns zwei beabstandete magnetische Leiter und ein sich zwischen den Leitern erstreckendes Flussleitstück mit einem umschlossenen magnetischen Modifikationselement, welches variabel in dem Flussleitstück positionierbar ist, um abhängig von der Position des Modifikationselements im Flussleitstück einen variablen magnetischen Widerstand zu erzeugen. Das magnetische Modifikationselement kann beispielsweise ein magnetischer Zylinder sein, der mehr oder weniger weit in eine entsprechende Bohrung des Flussleitstücks eingeschoben oder eingedreht werden kann. Die beiden oben genannten Zustände des magnetischen Potentiometers mit unterschiedlichem Widerstand können durch eine minimal bzw. maximal eingeschobene Position des Modifikationselements im Flussleitstück gebildet sein. Diese Ausführungsform ist mechanisch besonders stabil.

Gemäß einer weiteren vorteilhaften Ausgestaltung umfasst zumindest ein magnetisches Potentiometer des Magnetkerns zwei beabstandete magnetische Leiter und ein sich zwischen den Leitern erstreckendes Flussleitstück, welches mit einer magnetischen Modifikationsplatte kombinierbar ist, um abhängig von dem Vorhandensein oder Nichtvorhandensein der Modifikationsplatte einen variablen magnetischen Widerstand zu erzeugen. Diese Ausführungsform ist mechanisch besonders einfach.

Die genannten Elemente der magnetischen Potentiometer, insbesondere die magnetischen Flussleitstücke, das Modifikationselement bzw. die Modifikationsplatte sind vorteilhaft mit Materialien hoher relativer Permeabilität $\mu_r$ gebildet. Vorzugsweise haben die Materialien eine relative Permeabilität $\geq 50$, besonders bevorzugt sind Materialien mit einer relativen Permeabilität $\geq 200$. Weiter sind die genannten Elemente vorzugsweise aus einem Material mit hohen Sättigungsflussdichte, insbesondere $B_S \geq 1,0\,T$ oder sogar $B_S \geq 1,8$ gebildet, um eine Sättigung und damit ein Absinken der Permeabilität bei hohen Magnetfeldstärken zu vermeiden. Vorteilhafte Materialien sind weichmagnetische Materialien wie SiFe- und NiFe-Legierungen, CoFe- Legierungen, Weicheisen oder magnetische Stähle mit einem Kohlenstoffgehalt unterhalb von 0,55%.

Magnetische Potentiometer können mit Vorteil neben einem Zerlegespalt des Magnetkerns angeordnet sein, insbesondere können zwei magnetische Potentiometer auf beiden Seiten eines Zerlegespalts angeordnet sein. Diese Position ist gut für eine Verstellung zugänglich. Magnetische Potentiometer können mit Vorteil auch so angeordnet sein, dass sie einen Nebenschluss zwischen den Schenkeln und/oder Jochen des Magnetkerns und den Polschuhen und/oder Permanentmagneten des Magnetkerns erzeugen können. Dies ermöglicht eine besonders starke Reduktion der Zerlegekraft.

In einer vorteilhaften Ausgestaltung weist das Sensorelement weiter eine Modulationsspule zur Erzeugung eines zeitlich variierenden Magnetfelds in dem Luftspalt und einen Resonator zur Anregung des Spinresonanz-Merkmals des zu prüfenden Datenträgers auf. Der Resonator ist insbesondere auch zur Erfassung der Signalantwort des Spinresonanz-Merkmals ausgebildet und er kann vorteilhaft die Signalantwort des Spinresonanz-Merkmals aufnehmen und an einen Detektor ausgeben.

Das Sensorelement umfasst bevorzugt weiter eine Auswerteeinheit, die dazu eingerichtet ist, anhand der von dem Resonator erfassten Signalantwort des Spinresonanz-Merkmals ein Prüfergebnis zu erzeugen. Dazu wird bevorzugt eine aus der Signalantwort abgeleitete charakteristische Eigenschaft mit einem Referenzwert oder einem Referenzintervall verglichen, und bei ausreichend hoher Übereinstimmung ein positives Prüfergebnis ausgegeben, das zum Beispiel die Echtheit oder eine Klassenzugehörigkeit des geprüften Wertdokuments anzeigt. Als charakteristische Eigenschaften können beispielsweise die Resonanzfrequenz der Spinresonanz, deren Linienbreite oder Amplitude, eine Relaxationszeit der Spinresonanz oder die räumliche Verteilung des Spinresonanz-Merkmals herangezogen werden.

Die Spinresonanzen können beispielsweise mit einem Dauerstrich (CW)-Verfahren, einem gepulsten Verfahren oder einem Rapid-Scan-Verfahren bestimmt werden.

Die Erfindung enthält auch ein Verfahren zum Zerlegen eines Sensorelements der beschriebenen Art, bei dem das zumindest eine magnetische Potentiometer des Magnetkerns in den zweiten Zustand gebracht wird, und der Magnetkern entlang des zumindest einen Zerlegespalts zerlegt wird. Enthält das Sensorelement mehrere magnetische Potentiometer, werden vorteilhaft alle Potentiometer in den zweiten Zustand gebracht, um die größtmögliche Reduktion der Zerlegekraft zu erreichen.

Die Erfindung enthält weiter ein Verfahren zur Montage eines Sensorelements der beschriebenen Art. Bei dem Verfahren wird ein erstes Teilstück des Magnetkerns bereitgestellt, das zumindest einen Teil der genannten Polarisationseinrichtung zur Erzeugung des statischen magnetischen Flusses aufweist, und das zumindest ein zwischen zwei Zuständen schaltbares magnetisches Potentiometer aufweist, welches sich in dem zweiten Zustand befindet oder in den zweiten Zustand gebracht wird. Weiter wird ein zweites Teilstück des Magnetkerns bereitgestellt. Der Magnetkern des Sensorelements wird aus dem ersten und zweiten Teilstück montiert, so dass in dem Magnetkern einerseits ein Luftspalt ausgebildet wird, in dem durch die Polarisationseinrichtung ein statischer magnetischer Fluss erzeugt wird, und andererseits zumindest ein Zerlegespalt zwischen den Teilstücken ausgebildet wird. Nach der Montage des Magnetkerns wird das zumindest eine magnetische Potentiometer in den ersten Zustand gebracht, um das Sensorelement auf eine Messung an einem Spinresonanz-Merkmal eines in den Luftspalt eingebrachten Datenträgers einzurichten.

Enthält das Sensorelement mehrere magnetische Potentiometer, so werden die angegebenen Schritte vorteilhaft für alle magnetischen Potentiometer ausgeführt. Auch das zweite Teilstück des Magnetkerns kann einen Teil der genannten Polarisationseinrichtung zur Erzeugung des statischen magnetischen Flusses aufweisen und kann zumindest ein zwischen zwei Zuständen schaltbares magnetisches Potentiometer aufweisen. In diesem Fall werden die angegebenen Schritte vorteilhaft auch für die magnetischen Potentiometer des zweiten Teilstücks ausgeführt. Beispielsweise ist das Sensorelement nur dann auf eine Spinresonanz-Messung eingerichtet, wenn sich alle magnetischen Potentiometer des Magnetkerns im ersten Zustand befinden.

Die Erfindung enthält schließlich auch ein Verfahren zur Prüfung eines flächigen Datenträgers, insbesondere einer Banknote, mit einem Spinresonanz-Merkmal, mittels eines Sensorelements der beschriebenen Art. Bei dem Verfahren wird geprüft, ob sich das zumindest eine magnetische Potentiometer des Magnetkerns in dem ersten Zustand befindet und, falls dies nicht der Fall ist, wird das zumindest eine magnetische Potentiometer in den ersten Zustand gebracht. Dann wird ein zu prüfender flächiger Datenträger in den Luftspalt des Magnetkerns eingebracht und eine Spinresonanz-Messung an dem Datenträger vorgenommen.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:

Fig. 1 schematisch das Sensorelement einer erfindungsgemäßen Prüfvorrichtung eines Banknotenbearbeitungssystems im Regelbetrieb mit den in den ersten Zustand geschalteten magnetischen Potentiometern,

Fig. 2 das Sensorelement der Fig. 1 mit den für Montage-, Wartungs- oder Installationsaufgaben in den zweiten Zustand geschalteten magnetischen Potentiometern,

Fig. 3 den Aufbau und die Funktionsweise einiger erfindungsgemäß verwendeter magnetischer Potentiometer,

Fig. 4 magnetische Ersatzschaltbilder für das Sensorelement der Figuren 1 und 2, wobei (a) das vollständige magnetische Ersatzschaltbild zeigt, und (b) für $R_p \gg R_Z$ das idealisierte Ersatzschaltbild im Regelbetrieb der Fig. 1 zeigt,

Fig. 5 schematisch ein Sensorelement nach einem weiteren Ausführungsbeispiel der Erfindung im Regelbetrieb, wobei (a) die Seitenansicht des Sensorelements in der x-z-Ebene und (b) die Seitenansicht in der y-z-Ebene zeigt,

Fig. 6 in (a) und (b) das Sensorelement der Fig. 5 bei gleichen Ansichten im inoperablen Zustand,

Fig. 7 das vollständige magnetische Ersatzschaltbild des Sensorelements der Figuren 5 und 6,

Fig. 8 den Betrag der berechneten Streufelder der oberen Kreishälfte des Sensorelements entlang der mittigen Lotgeraden des Polschuhs in den zwei Konfiguration der Figuren 1 und 2, und

Fig. 9 die relative Zerlegekraft $F_{Z,rel}$ eines magnetischen Kreises nach Figuren 1 und 2 in Abhängigkeit vom Bolzendurchmesser d (obere x-Achse), bzw. dem Verhältnis zwischen dem Bezugswiderstand $R_{ref}$ im magnetischen Kreis und dem Potentiometerwiderstand $R_P$ der Potentiometer (untere x-Achse).

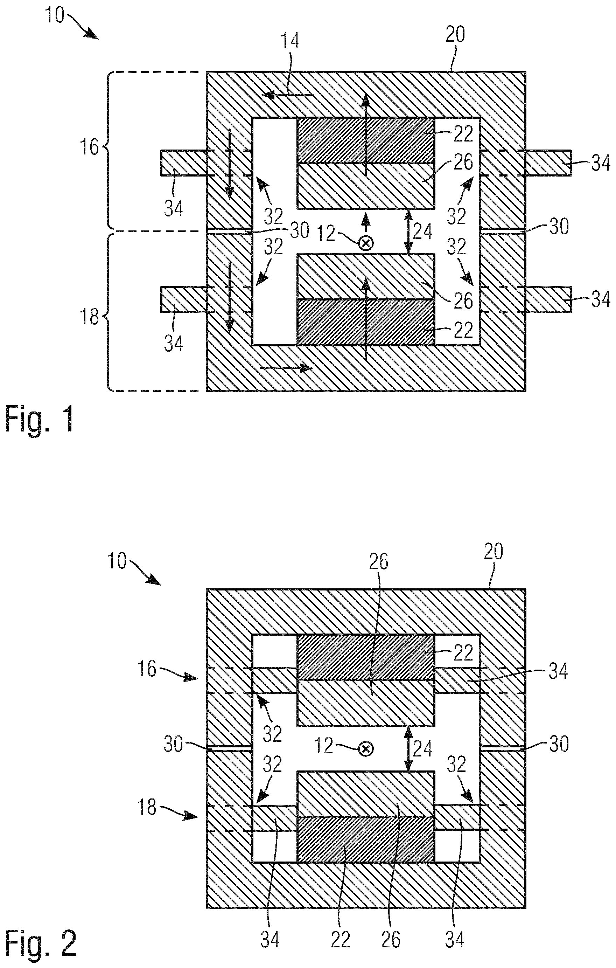

Die Erfindung wird nun am Beispiel von Sensorelementen für die Echtheitsprüfung von Banknoten erläutert. Die Figuren 1 und 2 zeigen dazu schematisch das Sensorelement 10 einer Prüfvorrichtung eines Banknotenbearbeitungssystems. Die selbst nicht dargestellten Banknotenprüflinge enthalten in einem Merkmalsbereich ein Spinresonanz-Merkmal, dessen charakteristische Eigenschaften insbesondere zum Nachweis der Echtheit der Banknote dienen. Die Prüflinge werden entlang eines Transportpfads 12 durch einen Luftspalt 24 des Sensorelements 10 geführt, der in der Darstellung der Figuren 1 und 2 senkrecht auf der Papierebene steht.

Das Sensorelement 10 der Figuren 1 und 2 enthält einen magnetischen Kreis, der wegen seiner Geometrie als H-Typ-Kreis bezeichnet wird. Der magnetische Kreis umfasst einen Magnetkern 20, der den magnetischen Fluss zweier Permanentmagnete 22 und in der Regel weiterer, in der Figur der Einfachheit halber nicht dargestellter, Spulenelemente zu einem Luftspalt 24 leitet, der sich in axialer Richtung zwischen den Polschuhen 26 des magnetischen Kreises erstreckt und in dem die Spinresonanzmessung an den Banknotenprüflingen stattfindet.

Der Magnetkern 20 bildet einen magnetischen Rückschluss für den magnetischen Fluss 14 der Permanentmagnete 22, der in Fig. 1 in der linken Hälfte des Sensorelements zur Illustration eingezeichnet ist. Die vertikalen Rückschlusselemente des Magnetkerns 20 werden dabei als Schenkel, die horizontalen Rückschlusselemente als Joche bezeichnet.

Der Magnetkern 20 weist weiter zwei Zerlegespalte 30 auf, an denen der magnetische Kreis für Montage-, Wartungs- oder Installationsaufgaben getrennt und in zwei Kreishälften 16, 18 zerlegt werden kann.

Wie weiter oben grundsätzlich beschrieben, wird für eine große Signalstärke bei der Banknotenprüfung eine hohe Feldstärke des Polarisationsfelds $B_0$ im Luftspalt 24 angestrebt. Mit zunehmendem permanent-magnetischen Polarisationsfeld steigen allerdings auch die Kräfte und Streufelder zwischen den Einzelkomponenten des magnetischen Kreises, die einerseits eine Zerlegung des Sensorelements erschweren und anderseits auch zu einer Gefährdung bei der Einlagerung eines in seine Einzelteile zerlegten magnetischen Kreises führen können.

Zur Überwindung dieser Probleme sind in dem Magnetkern 20 vier magnetische Potentiometer 32 vorgesehen, die den Regelbetrieb des Sensorelements bei der Banknotenprüfung nicht beeinflussen, die aber eine signifikante Reduktion der Zerlegekräfte und Streufelder ermöglichen.

Die magnetischen Potentiometer 32 sind jeweils zwischen zwei Zuständen schaltbar, die jeweils in den Figuren 1 und 2 illustriert sind. In dem in Fig. 1 gezeigten ersten Zustand der Potentiometer 32 befindet sich das Sensorelement 10 im Regelbetrieb und ist auf eine Messung an einem Spinresonanz-Merkmal eines Banknotenprüflings im Luftspalt 24 eingerichtet. In dem zweiten Zustand der Potentiometer 32, der in Fig. 2 illustriert ist, fließt ein substantieller Teil des magnetischen Flusses durch die Potentiometer 32 und verringert dadurch neben dem Fluss im Luftspalt 24 insbesondere auch den Fluss in den Zerlegespalten 30. Die Zerlegekräfte der beiden Kreishälften 16, 18 sind dadurch deutlich reduziert und erlauben eine leichtere Montage bzw. Demontage des magnetischen Kreises.

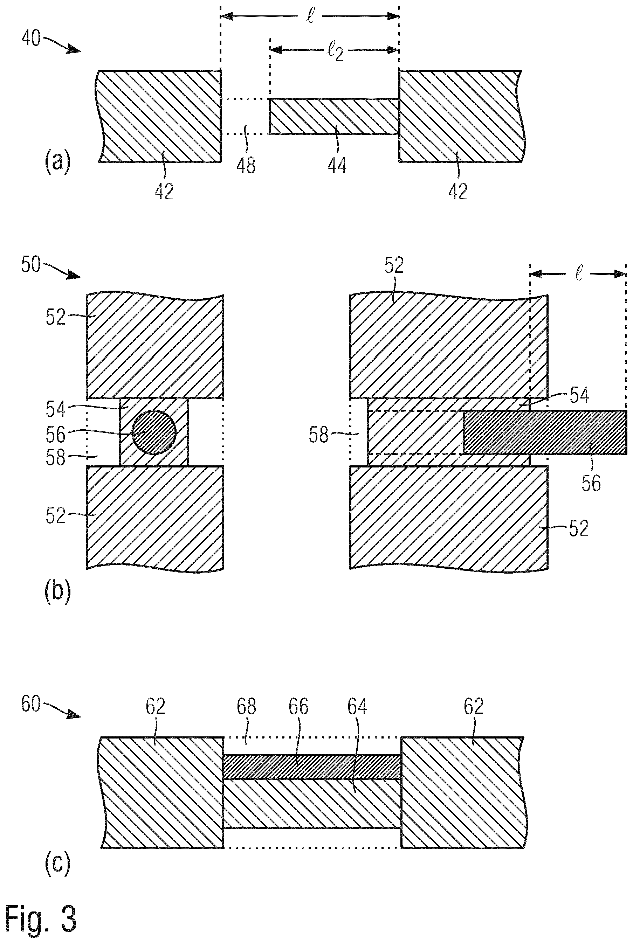

Um näher zu erläutern, wie der magnetische Fluss mit Hilfe der magnetischen Potentiometer 32 gezielt umgeleitet wird, wird zunächst mit Bezug auf Fig. 3 der Aufbau und die Funktionsweise einiger erfindungsgemäß verwendeter magnetischer Potentiometer genauer beschrieben.

Figur 3(a) zeigt eine erste Ausführungsform eines magnetischen Potentiometers 40, bei dem sich ein magnetisch leitender Zylinder 44 mit variabler Länge $l_2$ und Querschnittsfläche A zwischen zwei im Abstand l angeordneten magnetischen Leitern 42 erstreckt. Die Länge $l_2$ des Zylinders 44 kann im Allgemeinen zwischen 0 und l liegen, so dass zwischen den Leitern 42 neben dem magnetischen Zylinder 44 auch ein Freiraum 48 der Länge $l_1 = l - l_2$ vorliegt. Beträgt die relative Permeabilität des Materials des Zylinders 44 $\mu_2$ und wird die relative Permeabilität des Freiraums 48 mit $\mu_1$ bezeichnet, so ist der magnetische Gesamtwiderstand des zwischen den äußeren Leitern 42 gebildeten Potentiometers 40 näherungsweise gegeben durch

$$ R = l_1/(\mu_0\,\mu_1 A) + l_2/(\mu_0\,\mu_2 A) \;\; = (l-l_2)/(\mu_0\,\mu_1 A) + l_2/(\mu_0\,\mu_2 A), $$

mit der Permeabilität des Vakuums $\mu 0$.

Der magnetische Widerstand des Potentiometers 40 kann somit über die Länge $l_2$ des magnetisch leitenden Zylinders 44 eingestellt werden. Da für magnetische Materialien $\mu_2 > \mu_1$ gilt, ergibt sich ein maximaler magnetischer Widerstand des Potentiometers 40 für $l_2 = 0$ und ein minimaler magnetischer Widerstand für $l_2 = l$. In einem Sensorelement können diese beiden Extremwerte und die zugehörigen Stellungen des Zylinders 44 die beiden oben genannten Zustände unterschiedlichen magnetischen Widerstands des magnetischen Potentiometers 40 darstellen.

Eine zweite Ausführungsform eines magnetischen Potentiometers 50 ist in Fig. 3(b) in Vorder- und Seitenansicht gezeigt. Bei dem Potentiometer 50 stellt ein magnetisches Flussleitstück 54 eine Verbindung zwischen einem oberen und einem unteren magnetischen Leiter 52 her. Das Flussleitstück 54 ist aus einem Material mit relativer Permeabilität $\mu_2$ gebildet und umschließt einen in Längsrichtung verschiebbaren Zylinder 56 der Permeabilität $\mu_3 > \mu_1$. Das Flussleitstück 54 und der Zylinder 56 befinden sich einem Freiraum 58 der relativen Permeabilität $\mu_1$, der insbesondere auch die Bohrung im Flussleitstück 54 ausfüllt. Durch die Position l des Zylinders 56 innerhalb des Flussleitstücks 54 kann der magnetische Widerstand des Potentiometers 50 eingestellt werden. Insbesondere ergibt sich ein maximaler magnetischer Widerstand des Potentiometers 50 für $l = l_{max}$, also einen maximal weit herausgeschobenen Zylinder 56 und ein minimaler magnetischer Widerstand für $l = 0$, also einen vollständig in das Flussleitstück 54 eingeschobenen Zylinder 56. In einem Sensorelement können diese beiden Extremwerte und die zugehörigen Stellungen des Zylinders 56 relativ zu dem Flussleitstück 54 als die beiden oben genannten Zustände unterschiedlichen magnetischen Widerstands des Potentiometers 50 genutzt werden.

Figur 3(c) zeigt eine weitere Ausführungsform eines magnetischen Potentiometers 60. Dabei verbindet ein Flussleitstück 64 der relativen Permeabilität $\mu_2$ zwei äußere magnetische Leiter 62. Die relative Permeabilität des Freiraums 68 wird wieder mit $\mu_1$ bezeichnet. Durch das Hinzufügen einer Modifikationsplatte 66 mit der relativen Permeabilität $\mu_3 > \mu_1$ kann der magnetische Widerstand zwischen den beiden äußeren Leitern 62 reduziert werden. In einem ersten Zustand mit hinzugefügter Modifikationsplatte 66 ist der Widerstand des magnetischen Potentiometers 60 daher niedrig, in einem zweiten Zustand ohne Modifikationsplatte 66 hoch.

**Um zwei** Zustände mit einem möglichst großen Unterschied im magnetischen Widerstand bei kleinem Querschnitt der Potentiometerelemente zu erhalten, sind die Potentiometer 40, 50, 60 vorteilhaft mit Materialien hoher relativer Permeabilität $\mu_2$ bzw. $\mu_3$ gebildet. Die relative Permeabilität ist dabei vorzugsweise $\geq 50$. Besonders bevorzugt ist eine relative Permeabilität $\geq 200$. Um eine Sättigung und damit ein Absinken der Permeabilität bei hohen Magnetfeldstärken zu vermeiden, wird vorteilhaft ein Material mit einer hohen Sättigungsflussdichte gewählt, beispielsweise weichmagnetische Materialien mit $B_S \geq 1,0$ T, wie etwa SiFe- oder NiFe-Legierungen, oder weichmagnetische Materialien mit sogar $B_S \geq 1,8$ T, wie etwa CoFe- Legierungen, Weicheisen oder magnetische Stähle mit einem Kohlenstoffgehalt unterhalb von 0,55 %.

Zurückkommend auf die Darstellung der Figuren 1 und 2 sind in dem Sensorelement 10 in jeder der beiden Hälften des magnetischen Kreises 16, 18 zwei magnetische Potentiometer 32 vom Typ des Potentiometers 40 der Fig. 3(a) vorgesehen. Die magnetisch leitenden Zylinder der Potentiometer sind dabei jeweils durch weichmagnetische Gewindestangen 34 gebildet, die im ersten Zustand der Fig. 1 nach außen herausgeschraubt und im zweiten Zustand der Fig. 2 in den magnetischen Kreis hineingeschraubt sind. Wie im Zusammenhang mit Fig. 3(a) erläutert, ist der magnetische Widerstand der Potentiometer 32 im ersten Zustand (Fig. 1) maximal und im zweiten Zustand (Fig. 2) minimal. Die Potentiometer bilden daher im zweiten Zustand der Fig. 2 einen Nebenschluss innerhalb des magnetischen Kreises, der den Fluss im Luftspalt 24 und den Zerlegespalten 30 reduziert.

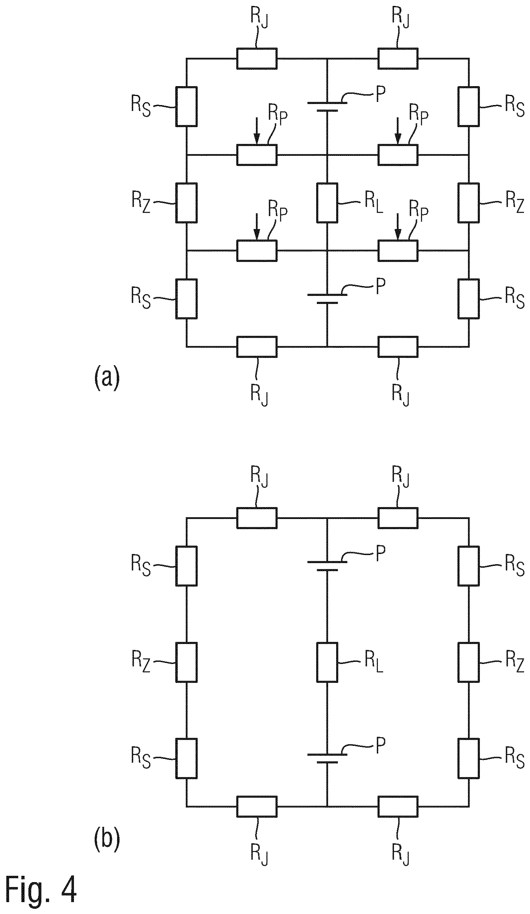

Die Reduktion des magnetischen Flusses mit Hilfe der Potentiometer 32 lässt sich anhand magnetischer Ersatzschaltbilder veranschaulichen. Figur 4 zeigt dazu in Fig. 4(a) das vollständige magnetische Ersatzschaltbild des Sensorelements 10 der Figuren 1 und 2, bei dem die Permanentmagneten 22 als Spannungsquellen P berücksichtigt sind und die magnetischen Elemente des Magnetkreises als Jochwiderstände $R_J$, als Schenkelwiderstände $R_S$, als Widerstände der Leiterelemente am Zerlegespalt $R_Z$ und als Luftspaltwiderstand $R_L$ eingezeichnet sind. Die variablen Widerstände der vier Potentiometer 32 sind mit $R_P$ bezeichnet. Die Polschuhe und eventuellen Spulenelemente sind der Einfachheit halber vernachlässigt.

Bei maximalem magnetischem Widerstand der Potentiometer 32, also im Regelbetriebszustand der Fig. 1, ist $R_p \gg R_Z$, so dass praktisch kein magnetischer Fluss über die Potentiometer 32 fließt. Dieser Zustand kann daher durch das idealisierte Ersatzschaltbild der Fig. 4(b) beschrieben werden, und es wird deutlich, dass der magnetische Fluss im Luftspalt 24 im Regelbetrieb des Sensorelements 10 durch die magnetischen Potentiometer 32 nicht gestört wird.

Für Montage- oder Zerlegearbeiten werden die Gewindestangen 34 in den magnetischen Kreis hineingeschraubt, der magnetische Widerstand der Potentiometer 32 dadurch minimiert, und durch den entstehenden Nebenschluss der magnetische Fluss im Luftspalt 24 und den Zerlegespalten 30 reduziert. Dabei hat sich überraschend gezeigt, dass bereits ein Potentiometerwiderstand $R_P \approx 3*R_Z$ ausreicht, um die Zerlegekraft deutlich zu reduzieren. Es fließt dann ein substantieller Teil des magnetischen Flusses durch die magnetischen Potentiometer 32, während gleichzeitig der Fluss im Luftspalt 24 und in den Zerlegespalten 30 reduziert wird.

Neben der Verringerung der Zerlegekräfte, die eine Montage und Demontage des magnetischen Kreises erleichtern, führt die Verlagerung des magnetischen Flusses vom Luftspalt 24 bzw. den Zerlegespalten 30 in die Potentiometerelemente 32 vorteilhaft auch dazu, dass sich geringere Streufelder in der Umgebung der Kreiselemente ausprägen, wie weiter unten im Detail beschrieben.

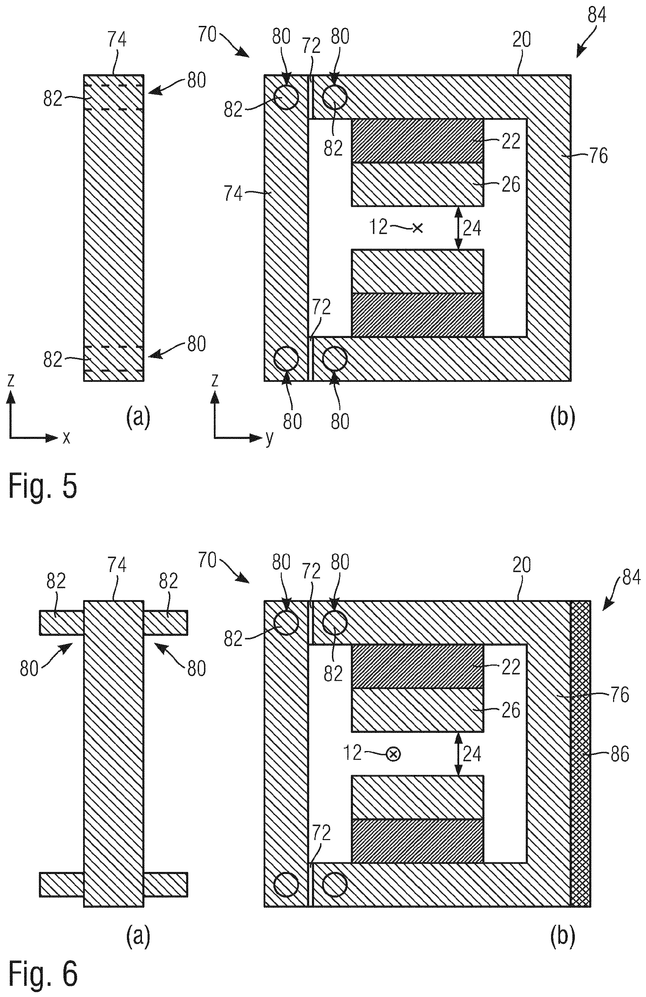

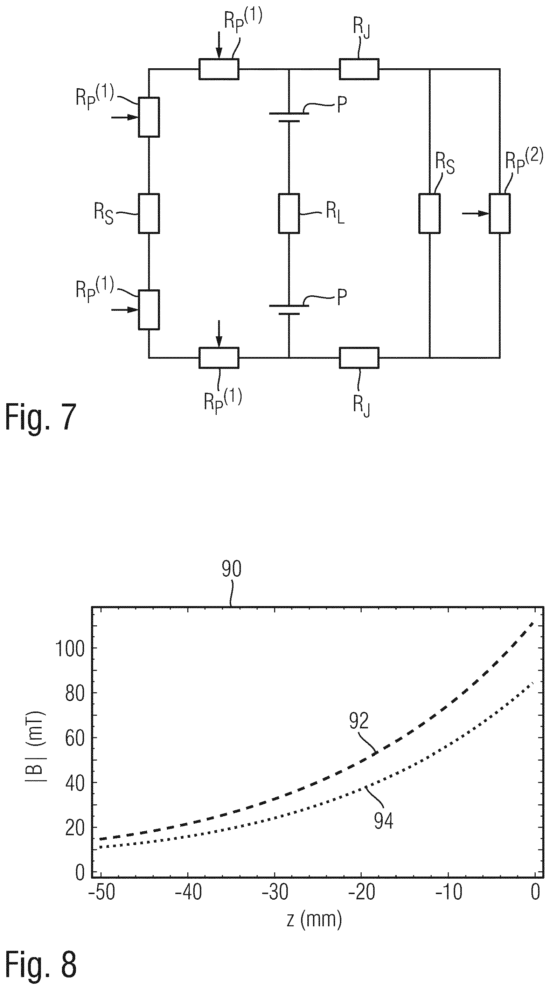

Ein weiteres Ausführungsbeispiel der Erfindung wird nunmehr mit Bezug auf die Figuren 5 bis 7 erläutert. Die Figuren 5 und 6 zeigen ein erfindungsgemäßes Sensorelement 70 jeweils in (a) in Seitenansicht in der x-z-Ebene und in (b) in Seitenansicht in der y-z-Ebene. Dabei ist das Sensorelement 70 in Fig. 5 im Regelbetrieb und in Fig. 6 im inoperablen, auf die Zerlegung eingerichteten Zustand dargestellt. Figur 7 zeigt das vollständige magnetische Ersatzschaltbild des Sensorelements 70.

Der magnetische Kreis des Sensorelements 70 ist ebenfalls vom H-Typ und enthält wie die Ausgestaltung der Figuren 1 und 2 einen Magnetkern 20 mit Permanentmagneten 22, einem magnetischen Rückschluss und einem sich zwischen zwei Polschuhen 26 erstreckenden Luftspalt 24, in dem die Spinresonanz-Messung stattfindet. Der magnetische Kreis enthält Zerlegespalte 72, die bei dem Sensorelement 70 allerdings so angeordnet sind, dass der ursprüngliche H-Typ-Kreis durch Abnahme des linken Kreisschenkels 74 zu einem C-Typ-Kreis demontiert werden kann. Dies stellt vor allem bei Wartungsarbeiten in Banknotenbearbeitungsmaschinen eine häufig auftretende Aufgabe dar. Tritt beispielsweise ein Banknotenstau in der Maschine auf, wird der Transportpfad 12 im Luftspalt 24 durch die Demontage des Kreisschenkels 74 zugänglich und der Banknotenstau kann leichter behoben werden.

Der Magnetkern 20 des Sensorelements 70 enthält zwei unterschiedliche Typen magnetischer Potentiometer 80, 84. Einerseits sind in unmittelbarer Nähe der beiden Zerlegespalte 72 jeweils zwei Potentiometer 80 der in Fig. 3(b) beschriebenen Art vorgesehen, die in Reihe in den magnetischen Kreis geschaltet sind. Die verschiebbaren Zylinder dieser Potentiometer sind in dem Sensorelement 70 durch weichmagnetische Gewindestangen 82 gebildet, die in den magnetischen Kreis hineingeschraubt (Fig. 5) oder weitgehend herausgeschraubt (Fig. 6) sein können. Wie im Zusammenhang mit Fig. 3(b) erläutert, ist der magnetische Widerstand der Potentiometer 80 im ersten, hineingeschraubten Zustand der Fig. 5 klein, im zweiten, herausgeschraubten Zustand der Fig. 6 dagegen wesentlich größer.

Die Reihenschaltung der Potentiometer 80 ist besonders gut in dem magnetischen Ersatzschaltbild der Fig. 7 zu erkennen, in dem neben den bereits aus Fig. 4 bekannten Elementen P, $R_J$ und $R_S$, die an den Zerlegespalten angeordneten Potentiometer 80 als **variable** magnetische Widerstände $R_p^{(1)}$ eingezeichnet sind. Der magnetische Widerstand des Zerlegespaltes wird der Einfachheit halber nicht gezeigt. Der magnetische Widerstand $R_s$ des Schenkels 74, der im Zerlegfall zu entfernen ist, bildet dabei natürlicherweise einen geeigneten Bezugswiderstand für die Größe der Potentiometerwiderstände $R_p^{(1)}$.

Am rechten Schenkel des Magnetkerns 20 ist ein magnetisches Potentiometer 84 der in Fig. 3(c) beschriebenen Art ausgebildet, wobei der rechte Schenkel 76 des Magnetkerns die Rolle des Flussleitstücks und eine abnehmbare weichmagnetische Platte 86 (Fig. 6) die Rolle der Modifikationsplatte übernimmt. Wie in Fig. 7 gezeigt, ist das Potentiometer 84 mit magnetischem Widerstand $R_p^{(2)}$ parallel in den magnetischen Kreis geschaltet.

Im Regelbetrieb der Fig. 5 sind die Gewindestangen 82 der Potentiometer 80 vollständig eingeschraubt, ihr in Serie geschalteter magnetischer Widerstand $R_p^{(1)}$ ist daher klein. Auf der anderen Seite ist die weichmagnetische Platte 86 des Potentiometers 84 abgenommen, so dass der parallel geschaltete magnetische Widerstand $R_p^{(2)}$ des Potentio-

meters 84 hoch ist, wie im Zusammenhang mit Fig. 3(c) erläutert. Im Regelbetrieb des Sensorelements 70 wird der magnetische Fluss im Luftspalt 24 durch die magnetischen Potentiometer 80, 84 daher nicht gestört.

Im Zerlegezustand der Fig. 6 sind die Gewindestangen 82 der Potentiometer 80 des ersten Typs herausgeschraubt, ihr in Serie geschalteter magnetischer Widerstand $R_p^{(1)}$ ist daher hoch, so dass sie den linken Kreisschenkel 74 mit magnetischen Widerstand $R_s$ weitgehend vom magnetischen Fluss abkoppeln. Im Potentiometer 84 des zweiten Typs ist die weichmagnetische Platte 86 nunmehr angebracht, so dass der parallel geschaltete magnetische Widerstand $R_p^{(2)}$ des Potentiometers 84 niedrig ist und der magnetische Fluss vom Luftspalt 24 und dem linken Kreisschenkel 74 weggeleitet wird. Der linke Kreisschenkel 74 kann daher für die Wartungsarbeiten leicht entfernt werden.

Anstelle der in den Ausführungsbeispielen zur Illustration gezeigten weichmagnetischen Gewindestangen und weichmagnetischen Platten können auch andere magnetischen Elemente mit hoher relativer Permeabilität verwendet werden, insbesondere weichmagnetische Bolzen, weichmagnetische Kegel-Elemente und weichmagnetische Flügel-Elemente.

Einige vorteilhafte Eigenschaften der erfindungsgemäßen Sensorelemente werden nunmehr anhand von Simulationen und Vergleichsrechnungen genauer erläutert.

Zunächst wurde der magnetische Kreis des Sensorelements 10 der Figuren 1 und 2 simuliert. Der magnetische Kreis enthält dabei zwei NdFeB-Permanentmagnete, sowie einen magnetischen Rückschluss und zwei Polschuhe, die aus einem weichmagnetischen Stahl mit einem Kohlenstoff-Gehalt < 0,19% und einer Sättigungsmagnetisierung von 2,05 T gebildet sind. Die Permanentmagnete weisen eine Remanenz von 1,29 T und Abmessungen von 30 mm x 60 mm x 20 mm auf. Ihre Magnetisierung ist parallel zur z-Achse gerichtet. Der magnetische Kreis hat ohne die magnetischen Potentiometer Außenkonturen von 30 mm x 140 mm x 140 mm. Die Joche und Schenkel haben einen Querschnitt von 20 mm x 30 mm. Im Zentrum des magnetischen Kreises befindet sich entlang der z-Achse ein Luftspalt einer Höhe von 20 mm.

Der magnetische Kreis enthält darüber hinaus zwei Zerlegespalte 30, die es erlauben, den Kreis in der x-y-Ebene zu trennen. In jedem der beiden Kreisschenkel befinden sich zwei magnetische Potentiometer 32, wobei jedes der Potentiometer 32 als Zylinderelement einen weichmagnetischen Bolzen enthält, der aus dem gleichen Material wie der Rückschluss gebildet ist. Der Durchmesser der weichmagnetischen Bolzen beträgt dabei jeweils 15 mm, seine nutzbare Länge 20 mm.

Für diesen magnetischen Kreis wurde nun die Zerlegekraft $F_Z$ berechnet, also diejenige Kraft, die mindestens notwendig ist, um die obere Kreishälfte 16 in z-Richtung von der unteren Kreishälfte 18 abzuziehen. Darüber hinaus wurde auch die $B_0$-Flussdichte im Zentrum des Luftspalts 24 bestimmt. Diese Flussdichte ist direkt proportional zur Resonanzfrequenz des Spinresonanzmerkmals und daher maßgeblich für die Betriebsfähigkeit des Sensorelements 10. Alle Berechnungen wurden jeweils für die beiden in den Figuren 1 und 2 dargestellten Zustände der Potentiometer 32 vorgenommen.

Als Konfiguration 1 bzw. erster Zustand wird die Konfiguration der Fig. 1 bezeichnet, in der sich der Magnetkreis im Regelbetrieb befindet und die Potentiometer 32 vollständig ausgefahren sind.

Als Konfiguration 2 bzw. zweiter Zustand wird die Konfiguration der Fig. 2 bezeichnet, in der sich der Magnetkreis in einem nicht-betriebsfähigen aber leicht zerlegbaren Zustand befindet. Die Potentiometer 32 erzeugen im zweiten Zustand einen Nebenschluss zwischen den Kreisschenkeln und den Polschuhen, beziehungsweise zwischen den Kreisschenkeln und den Permanentmagneten. Grundsätzlich ist es allerdings auch möglich, einen Nebenschluss nur zwischen den Kreisschenkeln und den Polschuhen oder nur zwischen den Kreisschenkeln und den Permanentmagneten zu erzeugen, oder einen Nebenschluss auch mit Hilfe des Kreisjochs zu erzeugen.

Die nachfolgende Tabelle I zeigt die Ergebnisse der Berechnung der Zerlegekraft $F_Z$ und der Flussdichte $B_0$ im Zentrum des Luftspalts in den beiden Konfigurationen.

**Tabelle I:**

| Konfiguration | $F_Z$ (N) | $B_0$ (mT) |
|---|---|---|
| 1 - Regelbetrieb, Fig. 1 | 450 | 330 |
| 2 - zerlegefähig, Fig. 2 | 230 | 250 |

Tabelle I zeigt, dass die Zerlegekraft $F_Z$ durch den Einsatz der magnetischen Potentiometer 32 um fast 50% reduziert wird. Diese Halbierung der aufzubringenden Kraft $F_Z$ erlaubt ein wesentlich komfortableres und sichereres Arbeiten bei Montage- und Wartungsaufgaben.

Gleichzeitig geht mit dem Abfall der Zerlegekraft $F_Z$ auch ein Abfall der Flussdichte $B_0$ im Luftspalt einher. Diese Verringerung der Flussdichte ist gleichbedeutend mit einer Verringerung der Resonanzfrequenz des Spin-Merkmals, vorliegend konkret um 24 %. Da die Bandbreite, innerhalb der beispielsweise ein Streifenleitungs-Resonator eines Sensorelements messfähig ist, typischerweise weniger als 1% der Grundfrequenz beträgt, ist bei dem starken Abfall des

Polarisationsfelds $B_0$ die Kombination aus magnetischem Kreis und Resonator in der Konfiguration 2 nicht mehr in der Lage, ein vorgegebenes Spinresonanz-Sicherheitsmerkmal zu vermessen. Dies ist jedoch unproblematisch, da Spinresonanz-Messungen nur mit dem Sensorelement in Konfiguration 1 ausgeführt werden sollen.

Neben einer Reduzierung der Zerlegekräfte verringert die Verwendung der erfindungsgemäßen Potentiometer 32 auch die auftretenden Streufelder eines zerlegten magnetischen Kreises.

Zur Illustration zeigt das Diagramm 90 der Fig. 8 den Betrag der berechneten Streufelder der oberen Kreishälfte 16 des Sensorelements 10 entlang der mittigen Lotgeraden des Polschuhs 26. Der Feldverlauf in Konfiguration 1 (Fig. 1) ist dabei als Kurve 92, der Feldverlauf in Konfiguration 2 (Fig. 2) als Kurve 94 dargestellt. Die Darstellung verläuft in negative z-Richtung (in den Figuren 1 bzw. 2 also von oben nach unten) und beginnt im Zentrum des Luftspalts 24 bei z=0. In beiden Konfigurationen wurde die untere Kreishälfte 18 jeweils entfernt.

Wie aus Fig. 8 ersichtlich, sind die Streufelder in Konfiguration 2 (Kurve 94) bei allen z-Werten niedriger als die Streufelder in Konfiguration 1 (Kurve 92). So ist etwa im Zentrum des Luftspalts 24 bei z=0 das Streufeld in Konfiguration 2 durch den geringen magnetischen Widerstand der Potentiometer 32 um 24% niedriger als das Streufeld in Konfiguration 1 bei hohen Potentiometerwiderständen.

In einer weiteren Simulationsrechnung wurde bei dem Sensorelement 10 der Figuren 1 und 2 der Einfluss der Gewinde- bzw. Bolzendurchmesser und damit der Einfluss des magnetischen Potentiometerwiderstands auf die Zerlegekraft näher untersucht.

Dazu wurden die magnetischen Potentiometer 32 des Sensorelements 10 mit Bolzen mit Durchmessern d im Bereich zwischen 2 mm und 20 mm simuliert, und die Zerlegekraft in z-Richtung bestimmt. Die Bohrungen in den Kreisschenkeln wurden dabei so bemessen, dass sie durch die jeweiligen Bolzen vollständig ausgefüllt werden.

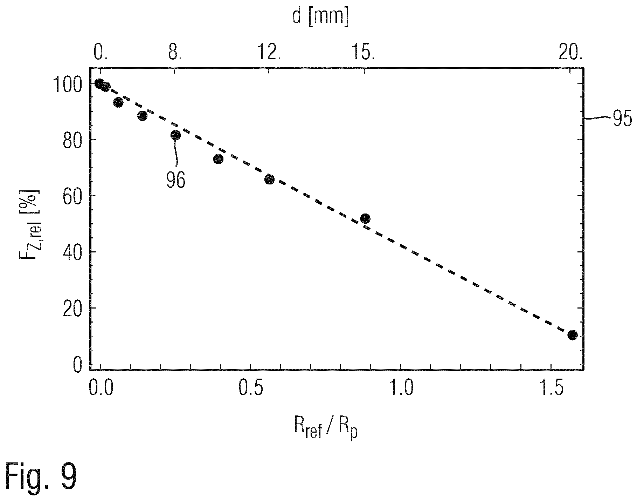

Die Berechnungsergebnisse sind dem Diagramm 95 der Fig. 9 zusammengefasst und veranschaulicht. Für jeden gewählten Bolzendurchmesser d, dargestellt auf der oberen x-Achse, wurde die Zerlegekraft berechnet, und zwar sowohl für vollständig eingeschraubte Bolzen (Fig. 2, minimaler Wert des Potentiometerwiderstands $R_P$) als auch für maximal herausgeschraubte Bolzen (Fig. 1, maximaler Wert des Potentiometerwiderstands $R_P$).

Die Fig. 9 zeigt auf der y-Achse die relative Zerlegekraft $F_{Z,rel}$, also für jeden Bolzendurchmesser d die Zerlegekraft $F_{Z,min}$ bei minimalem Potentiometerwiderstand (zweiter Zustand, leicht zerlegbar) bezogen auf die Zerlegekraft bei maximalem Potentiometerwiderstand $F_{Z,max}$ (erster Zustand, Regelbetrieb). Eine relative Zerlegekraft $F_{Z,rel}$ von 100% entspricht der Zerlegkraft der zur Spinresonanz-Messung eingerichteten Ausgangssituation der Fig. 1, eine relative Zerlegekraft von weniger als 100% zeigt eine entsprechende Verringerung der Zerlegekraft gegenüber der Ausgangssituation an.

Auf der unteren x-Achse ist das Verhältnis zwischen dem relevanten Bezugswiderstand $R_{ref}$ im magnetischen Kreis und dem minimalen Potentiometerwiderstand $R_P$ der Potentiometer 32 im zweiten, zerlegefähigen Zustand aufgetragen. Als relevanter Bezugswiderstand $R_{ref}$ ist dabei der Gesamtwiderstand des überbrückten magnetischen Rückschlusses zwischen den beiden Potentiometern der oberen und unteren Kreishälfte verwendet.

Aus der Darstellung der Fig. 9 ist ersichtlich, dass schon Potentiometerelemente mit einem Widerstandsverhältnis $R_{Ref}/R_P$ = 0.33 (entsprechend $R_P$ = 3*$R_{Ref}$) die Zerlegekraft um etwa 20 % reduzieren (entspricht in etwa Datenpunkt 96). Mit weiter abnehmendem magnetischem Widerstand, also mit zunehmendem Bolzendurchmesser d, setzt sich die Reduktion der Zerlegekraft fort. Bei Bolzen mit sehr großem Durchmesser d, insbesondere mit $R_{Ref}/R_P \geq 1$, wird die Zerlegekraft um etwa 60% reduziert und verschwindet bei noch größerem Bolzendurchmesser fast vollständig.

Mit einer weiteren Simulationsrechnung wurde der magnetische Kreis des Sensorelements 70 der Figuren 5 und 6 näher untersucht. Dabei sind im Regelbetrieb (Fig. 5) der Rückschluss, die Polschuhe und die verwendeten Permanentmagnete identisch zum magnetischen Kreis der Figuren 1 und 2. Im Folgenden wird diese Konfiguration als Konfiguration 1 bzw. erster Zustand bezeichnet. Anders als dieser weist das Sensorelement 70 allerdings vertikale Zerlegespalte 72 auf, mit denen der H-Typ-Kreis durch Demontage eines Schenkels 74 in einen C-Typ-Kreis überführt werden kann.

Zur Erleichterung der Demontage befinden sich nahe der beiden Zerlegespalte 72 weichmagnetische Gewindestangen mit einem Durchmesser von je 10 mm. Im Regelbetrieb der Fig. 5 sind die Gewindestangen in den Rückschluss eingeschraubt. Zur Demontage des Kreisschenkels 74 können die Gewindestangen halbseitig aus dem Rückschluss gedreht werden, wie in Fig. 6 illustriert. Zusätzlich kann an den rechten Kreisschenkel 76 eine weichmagnetische Platte 86, beispielsweise mit Abmessungen von 30 mm x 10 mm x 140 mm angebracht werden. Sowohl die Potentiometer-Gewindestangen 82 als auch die Potentiometer-Platte 86 sind für die Berechnung aus dem gleichen weichmagnetischen Stahl wie die Polschuhe und der Rückschluss gefertigt. Im Folgenden wird diese Konfiguration als Konfiguration 2 bzw. zweiter Zustand bezeichnet.

Für diesen magnetischen Kreis wurde wieder die Zerlegekraft $F_Z$ berechnet, wobei die Zerlegkraft in diesem Ausführungsbeispiel die Kraft darstellt, die mindestens notwendig ist, um den linken Kreisschenkel 74 in negative y-Richtung vom Kreis (in Fig. 5(b) und 6(b) also nach links) abzuziehen.

Die Berechnung wurde für die beiden in den Figuren 5 bzw. 6 dargestellten Konfigurationen mit den unterschiedlichen Zuständen der Potentiometer 80, 84 vorgenommen.

Tabelle II:

| Konfiguration | $F_Z$ (N) |
|---|---|
| 1 - Regelbetrieb, Fig. 5 | 756 |
| 2 - zerlegefähig, Fig. 6 | 467 |

Aus Tabelle II ist ersichtlich, dass durch die Potentiometer 80, 84 die notwendige Zerlegekraft zum Abziehen des Kreisschenkels 74 um fast 40% reduziert werden kann.

Darüber hinaus weist der magnetische Kreis in der Konfiguration der Fig. 6 eine starke Asymmetrie im Aufbau auf. Diese Asymmetrie spiegelt sich auch in der Verteilung des magnetischen Flusses im Kreis wieder und führt letztendlich zu einer asymmetrischen $B_0$-Verteilung im Luftspalt. Dies ist gleichbedeutend mit einer schlechten Feldhomogenität, die eine Banknoten-Messung erschwert. Dies ist jedoch unproblematisch, da Spinresonanz-Messungen nur mit dem Sensorelement in Konfiguration 1 ausgeführt werden sollen.

Bezugszeichenliste

10    Sensorelement
12    Transportpfad
16    obere Kreishälfte
18    untere Kreishälfte
20    Magnetkern
22    Permanentmagnete
24    Luftspalt
26    Polschuhe
30    Zerlegespalte
32    magnetische Potentiometer
34    weichmagnetische Gewindestangen
40    magnetisches Potentiometer
42    magnetische Leiter
44    magnetisch leitender Zylinder
48    Freiraum
50    magnetisches Potentiometer
52    magnetische Leiter
54    Flussleitstück
56    verschiebbarer Zylinder
58    Freiraum
60    magnetisches Potentiometer
62    magnetische Leiter
64    Flussleitstück
66    Modifikationsplatte
68    Freiraum
70    Sensorelement
72    Zerlegespalte
74    linker Kreisschenkel
76    rechter Kreisschenkel
80    magnetische Potentiometer (erster Typ)
82    weichmagnetische Gewindestangen
84    magnetisches Potentiometer (zweiter Typ)
86    weichmagnetische Platte
90    Diagramm
92    Feldverlauf in Konfiguration 1
94    Feldverlauf in Konfiguration 2
95    Diagramm
96    Datenpunkt $R_{Ref}/R_P = 0.33$

**Patentansprüche**

1.  Sensorelement (10) für die Prüfung eines flächigen Datenträgers, insbesondere einer Banknote, mit einem Spinresonanz-Merkmal, umfassend

    - einen Magnetkern (20) mit einem Luftspalt (24), in den der flächige Datenträger zur Prüfung einbringbar ist, und mit zumindest einem Zerlegespalt (30), entlang dem der Magnetkern (20) in zwei oder mehr Teile zerlegbar ist, und
    - eine Polarisationseinrichtung (22) zur Erzeugung eines statischen magnetischen Flusses in dem Luftspalt (24),

    **dadurch gekennzeichnet, dass**

    - der Magnetkern (20) zumindest ein zwischen zwei Zuständen schaltbares magnetisches Potentiometer (32) aufweist, wobei

      - - das magnetische Potentiometer (32) in einem ersten Zustand einen ersten magnetischen Widerstand aufweist, und das Sensorelement (10) in dem ersten Zustand des magnetischen Potentiometers (32) auf eine Messung an einem Spinresonanz-Merkmal eines in den Luftspalt (24) eingebrachten Datenträgers eingerichtet ist, und
      - - das magnetische Potentiometer (32) in einem zweiten Zustand einen vom ersten magnetischen Widerstand unterschiedlichen zweiten magnetischen Widerstand aufweist, und das Sensorelement (10) in dem zweiten Zustand des magnetischen Potentiometers (32) auf eine Zerlegung des Magnetkerns entlang des Zerlegespalts (30) eingerichtet ist, so dass eine Zerlegekraft zur Zerlegung des Magnetkerns entlang des zumindest einen Zerlegespalts (30) im zweiten Zustand kleiner ist als die Zerlegekraft im ersten Zustand.

2.  Sensorelement (10) nach Anspruch 1, **dadurch gekennzeichnet, dass** das zumindest eine magnetische Potentiometer (32) so ausgebildet ist, dass es im ersten Zustand im Wesentlichen keinen Einfluss auf den magnetischen Fluss im Luftspalt hat.

3.  Sensorelement (10) nach wenigstens einem der Ansprüche 1 oder 2, **dadurch gekennzeichnet, dass** die Zerlegekraft zur Zerlegung des Magnetkerns entlang des zumindest einen Zerlegespalts (30) im zweiten Zustand zumindest 20%, insbesondere zumindest 40% kleiner ist als die Zerlegekraft im ersten Zustand.

4.  Sensorelement (10) nach wenigstens einem der Ansprüche 1 bis **3, dadurch gekennzeichnet, dass** für eine Zerlegung des Magnetkerns (20) ein magnetischer Leiter mit einem magnetischen Widerstand $R_{ref}$ mit Hilfe eines magnetischen Potentiometers (32) zu überbrücken ist, wobei das magnetische Potentiometer (32) parallel zu dem zu überbrückenden Leiter geschaltet ist, und dass vorzugsweise das magnetische Potentiometer (32) im ersten Zustand einen magnetischen Widerstand $R_P$ von mindestens 10* $R_{ref}$ aufweist.

5.  Sensorelement (10) nach Anspruch 4, **dadurch gekennzeichnet, dass** das magnetische Potentiometer (32) im zweiten Zustand einen magnetischen Widerstand $R_P$ von höchstens 3* $R_{ref}$ aufweist.

6.  Sensorelement (10) nach wenigstens einem der Ansprüche 1 bis 5, **dadurch gekennzeichnet, dass** für eine Zerlegung des Magnetkerns ein magnetischer Leiter mit einem magnetischen Widerstand $R_{ref}$ mit Hilfe eines magnetischen Potentiometers (32) flussfrei zu schalten ist, wobei das magnetische Potentiometer (32) in Serie mit dem flussfrei zu schaltenden Leiter geschaltet ist, und dass vorzugsweise das magnetische Potentiometer (32) im ersten Zustand einen magnetischen Widerstand $R_P$ von höchstens 1/3* $R_{ref}$ aufweist.

7.  Sensorelement (10) nach Anspruch 6, **dadurch gekennzeichnet, dass** das magnetische Potentiometer (32) im zweiten Zustand einen magnetischen Widerstand $R_P$ von mindestens 3* $R_{ref}$ aufweist.

8.  Sensorelement (10) nach wenigstens einem der Ansprüche 1 bis 7, **dadurch gekennzeichnet, dass** im zweiten Zustand des magnetischen Potentiometers (32) der magnetische Fluss durch den Luftspalt (24) gegenüber dem magnetischen Fluss im ersten Zustand um mehr als 5% verändert ist, und/oder dass die Feldhomogenität im Luftspalt um mehr als 10% verringert ist.

9.  Sensorelement (10) nach wenigstens einem der Ansprüche 1 bis 8, **dadurch gekennzeichnet, dass** zwei oder mehr magnetische Potentiometer (32), insbesondere zumindest zwei magnetische Potentiometer unterschiedlichen Typs (80, 84) vorgesehen sind.

10. Sensorelement (10) nach wenigstens einem der Ansprüche 1 bis **9, dadurch gekennzeichnet, dass** zumindest ein magnetisches Potentiometer (32) des Magnetkerns (20) zwei beabstandete magnetische Leiter und ein magnetisches Flussleitstück umfasst, welches sich mit variabler Länge im Freiraum zwischen den beiden Leitern erstreckt, um abhängig von der Länge des Flussleitstücks einen variablen magnetischen Widerstand zu erzeugen.

11. Sensorelement (10) nach wenigstens einem der Ansprüche 1 bis 10, **dadurch gekennzeichnet, dass** zumindest ein magnetisches Potentiometer (80) des Magnetkerns (20) zwei beabstandete magnetische Leiter und ein sich zwischen den Leitern erstreckendes Flussleitstück mit einem umschlossenen magnetischen Modifikationselement umfasst, welches variabel in dem Flussleitstück positionierbar ist, um abhängig von der Position des Modifikationselements im Flussleitstück einen variablen magnetischen Widerstand zu erzeugen.

12. Sensorelement (10) nach wenigstens einem der Ansprüche 1 bis **11, dadurch gekennzeichnet, dass** zumindest ein magnetisches Potentiometer (84) des Magnetkerns (20) zwei beabstandete magnetische Leiter und ein sich zwischen den Leitern erstreckendes Flussleitstück umfasst, welches mit einer magnetischen Modifikationsplatte kombinierbar ist, um abhängig von dem Vorhandensein oder Nichtvorhandensein der Modifikationsplatte einen variablen magnetischen Widerstand zu erzeugen.

13. Sensorelement (10) nach wenigstens einem der Ansprüche 1 bis 12, **dadurch gekennzeichnet, dass** das Sensorelement (10) eine Modulationsspule zur Erzeugung eines zeitlich variierenden Magnetfelds in dem Luftspalt und einen Resonator zur Anregung des Spinresonanz-Merkmals des zu prüfenden Datenträgers aufweist.

14. Verfahren zum Zerlegen eines Sensorelements (10) nach einem der Ansprüche 1 bis 13, bei dem das zumindest eine magnetische Potentiometer (32) des Magnetkerns in den zweiten Zustand gebracht wird und der Magnetkern entlang des zumindest einen Zerlegespalts (30) zerlegt wird.

15. Verfahren zur Montage eines Sensorelements (10) nach einem der Ansprüche 1 bis 13, bei dem

   - ein erstes Teilstück des Magnetkerns (20) bereitgestellt wird, das zumindest einen Teil der genannten Polarisationseinrichtung zur Erzeugung des statischen magnetischen Flusses aufweist, und das zumindest ein zwischen zwei Zuständen schaltbares magnetisches Potentiometer (32) aufweist, welches sich in dem zweiten Zustand befindet oder in den zweiten Zustand gebracht wird,
   - ein zweites Teilstück des Magnetkerns (20) bereitgestellt wird,
   - der Magnetkern (20) des Sensorelements (10) aus dem ersten und zweiten Teilstück montiert wird, so dass in dem Magnetkern (20) einerseits ein Luftspalt (24) ausgebildet wird, in dem durch die Polarisationseinrichtung ein statischer magnetischer Fluss erzeugt wird, und andererseits zumindest ein Zerlegespalt (30) zwischen den Teilstücken ausgebildet wird,
   - nach der Montage des Magnetkerns (20) das zumindest eine magnetische Potentiometer (32) in den ersten Zustand gebracht wird, um das Sensorelement (10) auf eine Messung an einem Spinresonanz-Merkmal eines in den Luftspalt eingebrachten Datenträgers einzurichten.

16. Verfahren zur Prüfung eines flächigen Datenträgers, insbesondere einer Banknote, mit einem Spinresonanz-Merkmal, mittels eines Sensorelements (10) nach einem der Ansprüche 1 bis 13, bei dem

   - geprüft wird, ob sich das zumindest eine magnetische Potentiometer (32) des Magnetkerns (20) in dem ersten Zustand befindet und es, falls dies nicht der Fall ist, in den ersten Zustand gebracht wird, und
   - ein zu prüfender flächiger Datenträger in den Luftspalt (24) des Magnetkerns (20) eingebracht und eine Spinresonanz-Messung an dem Datenträger vorgenommen wird.

**Claims**

1. Sensor element (10) for the inspection of a planar data carrier, in particular a banknote, having a spin-resonance feature, comprising

   - a magnetic core (20) with an air gap (24), into which the planar data carrier is capable of being inserted for the purpose of inspection, and with at least one disassembly gap (30), along which the magnetic core (20) is capable of being disassembled into two or more parts, and
- a polarization device (22) for generating a static magnetic flux in the air gap (24),

**characterized in that**

- the magnetic core (20) exhibits at least one magnetic potentiometer (32) capable of being switched between two states, wherein

- in a first state the magnetic potentiometer (32) exhibits a first magnetic reluctance, and in the first state of the magnetic potentiometer (32) the sensor element (10) has been set up for a measurement in respect of a spin-resonance feature of a data carrier inserted into the air gap (24), and
- in a second state the magnetic potentiometer (32) exhibits a second magnetic reluctance, different from the first magnetic reluctance, and in the second state of the magnetic potentiometer (32) the sensor element (10) has been set up for a disassembly of the magnetic core along the disassembly gap (30), with the result that a disassembly force for disassembling the magnetic core along the at least one disassembly gap (30) is smaller in the second state than the disassembly force in the first state.

2. Sensor element (10) according to Claim 1, **characterized in that** the at least one magnetic potentiometer (32) has been designed in such a way that in the first state it has substantially no influence on the magnetic flux in the air gap.

3. Sensor element (10) according to at least one of Claims 1 and 2, **characterized in that** the disassembly force for disassembling the magnetic core along the at least one disassembly gap (30) is at least 20% smaller in the second state, in particular at least 40% smaller, than the disassembly force in the first state.

4. Sensor element (10) according to at least one of Claims 1 to 3, **characterized in that** for a disassembly of the magnetic core (20) a magnetic conductor with a magnetic reluctance $R_{ref}$ has to be bridged with the aid of a magnetic potentiometer (32), the magnetic potentiometer (32) being connected in parallel with the conductor to be bridged, and **in that** the magnetic potentiometer (32) in the first state preferably exhibits a magnetic reluctance $R_P$ of at least 10 * $R_{ref}$.

5. Sensor element (10) according to Claim 4, **characterized in that** the magnetic potentiometer (32) in the second state exhibits a magnetic reluctance $R_P$ of at most 3 * $R_{ref}$.

6. Sensor element (10) according to at least one of Claims 1 to 5, **characterized in that** for a disassembly of the magnetic core a magnetic conductor with a magnetic reluctance $R_{ref}$ has to be switched to be flux-free with the aid of a magnetic potentiometer (32), the magnetic potentiometer (32) being connected in series with the conductor to be switched to be flux-free, and **in that** the magnetic potentiometer (32) in the first state preferably exhibits a magnetic reluctance $R_P$ of at most 1/3 * $R_{ref}$.

7. Sensor element (10) according to Claim 6, **characterized in that** the magnetic potentiometer (32) in the second state exhibits a magnetic reluctance $R_P$ of at least 3 * $R_{ref}$.

8. Sensor element (10) according to at least one of Claims 1 to 7, **characterized in that** in the second state of the magnetic potentiometer (32) the magnetic flux through the air gap (24) has been changed by more than 5% in comparison with the magnetic flux in the first state, and/or **in that** the field homogeneity in the air gap has been diminished by more than 10%.

9. Sensor element (10) according to at least one of Claims 1 to 8, **characterized in that** two or more magnetic potentiometers (32), in particular at least two magnetic potentiometers of different types (80, 84), have been provided.

10. Sensor element (10) according to at least one of Claims 1 to 9, **characterized in that** at least one magnetic potentiometer (32) of the magnetic core (20) includes two spaced magnetic conductors and a magnetic flux-conducting part which extends with variable length within the free space between the two conductors in order to generate a variable magnetic reluctance, depending on the length of the flux-conducting part.

11. Sensor element (10) according to at least one of Claims 1 to 10, **characterized in that** at least one magnetic potentiometer (80) of the magnetic core (20) includes two spaced magnetic conductors and a flux-conducting part extending between the conductors with an enclosed magnetic modification element that is capable of being variably positioned in the flux-conducting part in order to generate a variable magnetic reluctance, depending on the position of the modification element in the flux-conducting part.

12. Sensor element (10) according to at least one of Claims 1 to 11, **characterized in that** at least one magnetic potentiometer (84) of the magnetic core (20) includes two spaced magnetic conductors and a flux-conducting part extending between the conductors that is capable of being combined with a magnetic modification plate in order to generate a variable magnetic reluctance, depending on the presence or absence of the modification plate.

13. Sensor element (10) according to at least one of Claims 1 to 12, **characterized in that** the sensor element (10) exhibits a modulation coil for generating a temporally varying magnetic field in the air gap, and a resonator for exciting the spin-resonance feature of the data carrier to be inspected.

14. Method for disassembling a sensor element (10) according to one of Claims 1 to 13, in which the at least one magnetic potentiometer (32) of the magnetic core is brought into the second state and the magnetic core is disassembled along the at least one disassembly gap (30).

15. Method for assembling a sensor element (10) according to one of Claims 1 to 13, in which

- a first portion of the magnetic core (20) is made available that exhibits at least a part of the stated polarization device for generating the static magnetic flux and that exhibits at least one magnetic potentiometer (32) capable of being switched between two states, which is in the second state or is brought into the second state,
- a second portion of the magnetic core (20) is made available,
- the magnetic core (20) of the sensor element (10) is assembled from the first and second portions, so that, on the one hand, an air gap (24) is formed in the magnetic core (20), in which a static magnetic flux is generated by the polarization device, and, on the other hand, at least one disassembly gap (30) is formed between the portions,
- after the assembly of the magnetic core (20), the at least one magnetic potentiometer (32) is brought into the first state in order to set up the sensor element (10) for a measurement in respect of a spin-resonance feature of a data carrier inserted into the air **gap.**

16. Method for inspecting a planar data carrier, in particular a banknote, having a spin-resonance feature by means of a sensor element (10) according to one of Claims 1 to 13, in which

- an inspection is made as to whether the at least one magnetic potentiometer (32) of the magnetic core (20) is in the first state, and if this is not the case the magnetic potentiometer is brought into the first state, and
- a planar data carrier to be inspected is inserted into the air gap (24) of the magnetic core (20), and a measurement of spin resonance is performed in respect of the data carrier.

**Revendications**

1. Élément capteur (10) pour le contrôle d'un support de données plat, notamment un billet de banque, présentant une caractéristique de résonance de spin, comprenant

- un noyau magnétique (20) pourvu d'un entrefer (24) dans lequel le support de données plat peut être inséré en vue du contrôle, et pourvu d'au moins une fente de démontage (30) le long de laquelle le noyau magnétique (20) peut être démonté en deux parties ou plus, et
- un dispositif de polarisation (22) destiné à générer un flux magnétique statique dans l'entrefer (24),

**caractérisé en ce que**

- le noyau magnétique (20) possède au moins un potentiomètre magnétique (32) commutable entre deux états,
- le potentiomètre magnétique (32) présentant, dans un premier état, une première résistance magnétique, et l'élément capteur (10) étant, dans le premier état du potentiomètre magnétique (32), réglé pour une mesure sur une caractéristique de résonance de spin d'un support de données introduit dans l'entrefer (24), et
- le potentiomètre magnétique (32) présentant, dans un deuxième état, une deuxième résistance magnétique différente de la première résistance magnétique, et l'élément capteur (10) étant conçu pour, dans le deuxième état du potentiomètre magnétique (32), un démontage du noyau magnétique le long de la fente de démontage (30), de sorte qu'une force de démontage pour le démontage du noyau magnétique le long de l'au moins une fente de démontage (30) dans le deuxième état est inférieure à la force de démontage dans le premier état.

2. Élément capteur (10) selon la revendication 1, **caractérisé en ce que** l'au moins un potentiomètre magnétique (32) est configuré de telle sorte que, dans le premier état, il n'a sensiblement aucune influence sur le flux magnétique dans l'entrefer.

3. Élément capteur (10) selon au moins l'une des revendications 1 ou 2, **caractérisé en ce que** la force de démontage pour le démontage du noyau magnétique le long d'au moins une fente de démontage (30) dans le deuxième état est inférieure d'au moins 20 %, en particulier d'au moins 40 %, à la force de démontage dans le premier état.

4. Élément capteur (10) selon au moins l'une des revendications 1 à 3, **caractérisé en ce que**, pour un démontage du noyau magnétique (20), un conducteur magnétique ayant une résistance magnétique $R_{ref}$ doit être shunté à l'aide d'un potentiomètre magnétique (32), le potentiomètre magnétique (32) étant branché en parallèle avec le conducteur à shunter, et **en ce que**, de préférence, le potentiomètre magnétique (32) présente, dans le premier état, une résistance magnétique $R_P$ égale au moins à $10*R_{ref}$.

5. Élément capteur (10) selon la revendication 4, **caractérisé en ce que** le potentiomètre magnétique (32) présente, dans le deuxième état, une résistance magnétique $R_P$ égale au plus à $3*R_{ref}$.

6. Élément capteur (10) selon au moins l'une des revendications 1 à 5, **caractérisé en ce que**, pour un démontage du noyau magnétique, un conducteur magnétique ayant une résistance magnétique $R_{ref}$ doit être mis hors flux à l'aide d'un potentiomètre magnétique (32), le potentiomètre magnétique (32) étant branché en série avec le conducteur à mettre hors flux, et **en ce que**, de préférence, le potentiomètre magnétique (32) présente, dans le premier état, une résistance magnétique $R_P$ égale au plus à $1/3*R_{ref}$.

7. Élément capteur (10) selon la revendication 6, **caractérisé en ce que** le potentiomètre magnétique (32) présente, dans le deuxième état, une résistance magnétique $R_P$ égale au moins à $3*R_{ref}$.

8. Élément capteur (10) selon au moins l'une des revendications 1 à 7, **caractérisé en ce que**, dans le deuxième état du potentiomètre magnétique (32), le flux magnétique à travers l'entrefer (24) est modifié de plus de 5 % par rapport au flux magnétique dans le premier état, et/ou **en ce que** l'homogénéité du champ dans l'entrefer est réduite de plus de 10 %.

9. Élément capteur (10) selon au moins l'une des revendications 1 à 8, **caractérisé en ce que** deux potentiomètres magnétiques (32) ou plus, notamment au moins deux potentiomètres magnétiques de types différents (80, 84), sont prévus.

10. Élément capteur (10) selon au moins l'une des revendications 1 à 9, **caractérisé en ce qu'**au moins un potentiomètre magnétique (32) du noyau magnétique (20) comporter deux conducteurs magnétiques espacés et un élément conducteur de flux magnétique, lequel s'étend sur une longueur variable dans l'espace libre entre les deux conducteurs afin de générer une résistance magnétique variable en fonction de la longueur de l'élément conducteur de flux.

11. Élément capteur (10) selon au moins l'une des revendications 1 à 10, **caractérisé en ce qu'**au moins un potentiomètre magnétique (80) du noyau magnétique (20) comporte deux conducteurs magnétiques espacés et un élément conducteur de flux qui s'étend entre les conducteurs avec un élément de modification magnétique enfermé, lequel peut être positionné de manière variable dans l'élément conducteur de flux afin de générer une résistance magnétique variable en fonction de la position de l'élément de modification dans l'élément conducteur de flux.

12. Élément capteur (10) selon au moins l'une des revendications 1 à 11, **caractérisé en ce qu'**au moins un potentiomètre magnétique (84) du noyau magnétique (20) comporte deux conducteurs magnétiques espacés et un élément conducteur de flux qui s'étend entre les conducteurs, lequel peut être combiné avec une plaque de modification magnétique afin de générer une résistance magnétique variable en fonction de la présence ou de l'absence de la plaque de modification.

13. Élément capteur (10) selon au moins l'une des revendications 1 à 12, **caractérisé en ce que** l'élément capteur (10) possède une bobine de modulation destinée à générer un champ magnétique variant dans le temps dans l'entrefer et un résonateur destiné à exciter la caractéristique de résonance de spin du support de données à contrôler.

14. Procédé de démontage d'un élément capteur (10) selon l'une des revendications 1 à 13, avec lequel l'au moins un potentiomètre magnétique (32) du noyau magnétique est amené dans le deuxième état et le noyau magnétique est démonté le long de l'au moins une fente de démontage (30).

15. Procédé de montage d'un élément capteur (10) selon l'une des revendications 1 à 13, avec lequel

- une première portion du noyau magnétique (20) est fournie, qui comporte au moins une partie dudit dispositif de polarisation destiné à générer le flux magnétique statique, et qui possède au moins un potentiomètre magnétique (32) commutable entre deux états, lequel se trouve dans le deuxième état ou est amené dans le deuxième état,
- une deuxième portion du noyau magnétique (20) est fournie,
- le noyau magnétique (20) de l'élément capteur (10) est monté à partir des première et deuxième portions de sorte que, d'une part, un entrefer (24) est formé dans le noyau magnétique (20), dans lequel un flux magnétique statique est généré par le dispositif de polarisation et, d'autre part, au moins une fente de démontage (30) est formée entre les portions,
- après le montage du noyau magnétique (20), l'au moins un potentiomètre magnétique (32) est amené dans le premier état afin de régler l'élément capteur (10) pour une mesure sur une caractéristique de résonance de spin d'un support de données introduit dans l'entrefer.

16. Procédé de contrôle d'un support de données plat, notamment un billet de banque, présentant une caractéristique de résonance de spin, au moyen d'un élément capteur (10) selon l'une des revendications 1 à 13, avec lequel

- un contrôle est effectué afin de vérifier si l'au moins un potentiomètre magnétique (32) du noyau magnétique (20) se trouve dans le premier état et, si ce n'est pas le cas, il est amené dans le premier état, et
- un support de données plat à contrôler est introduit dans l'entrefer (24) du noyau magnétique (20) et une mesure de résonance de spin est effectuée sur le support de données.

Fig. 1

Fig. 2

40

ℓ

ℓ$_2$

(a)

42    48    44    42

50

52    52

54    54

56    56

58    58

52    52

ℓ

(b)

60

62    68    66    64    62

(c)

Fig. 3

(a)

(b)

Fig. 4

Fig. 5

Fig. 6

Fig. 7

Fig. 8

Fig. 9

**IN DER BESCHREIBUNG AUFGEFÜHRTE DOKUMENTE**

**In der Beschreibung aufgeführte Patentdokumente**

- CN 203931702 U